# EUROPEAN PATENT APPLICATION

(11) **EP 4 574 343 A1**
(43) Date of publication of application: **25.06.2025**
(21) Application number: 24208530.6
(22) Date of filing: 24.10.2024
(51) Int. Cl.: B25F 5/02, H01M 50/247, H05K 3/28

(54) **POWER TOOL**

(30) Priority: 22.12.2023 CN 202311788977
(71) Applicant: Nanjing Chervon Industry Co., Ltd., Nanjing, Jiangsu 211106 (CN)
(72) Inventor: CHENG, Yugang, Nanjing, Jiangsu 211106, (CN)
(74) Representative: Sun, Yiming

(57) **Abstract**

A power tool includes an electric motor including a drive shaft rotating about a drive axis; an output portion driven by the electric motor to output power; a housing for accommodating the electric motor; and at least one print circuit board (PCB) electrically connected to the electric motor, where at least part of the at least one PCB is covered with a three-dimensional (3D) printed protective layer. In this manner, the automated device is used to accurately coat regions to be protected on the PCB, and 3D printed protective layers may be stacked layer by layer, thereby improving the protection efficiency and reducing material waste.

## Description

### TECHNICAL FIELD

The present application relates to an electrical control device and, in particular, to a power tool, a power device, and a battery pack.

### BACKGROUND

The printed circuit board (PCB) is widely used in electrical control devices. After the PCB is manufactured, the surface of the PCB needs to be protected. The surface protection of the PCB of the current product adopts the manual hand brushing process with G6 silicone. This method is inefficient, lots of glue materials are wasted, and excess glue on the appearance inspection station needs to be removed, resulting in serious material waste and making it difficult to achieve automated operations.

### SUMMARY

An object of the present application is to solve or at least alleviate part or all of the preceding problems. For this reason, the object of the present application is to provide a power tool, a power device, and a battery pack.

To achieve this object, the present invention adopts the technical solutions below.

A power tool includes an electric motor, an output portion, a housing, and at least one PCB. The electric motor includes a drive shaft rotating about a drive axis. The output portion is driven by the electric motor to output power. The housing accommodates the electric motor. At least one PCB is electrically connected to the electric motor, where at least part of the at least one PCB is covered with a three-dimensional (3D) printed protective layer.

In some examples, the thickness of the 3D printed protective layer is greater than or equal to 20 µm and less than or equal to 2000 µm.

In some examples, at least two regions on a PCB of the at least one PCB are covered with the 3D printed protective layer with different thicknesses.

In some examples, a region on a PCB of the at least one PCB is covered with a 3D printed enclosure layer.

In some examples, a region enclosed by the enclosure layer is capable of being covered with a protective layer different from the 3D printed protective layer.

In some examples, the 3D printed protective layer is formed by spraying a PCB of the at least one PCB multiple times.

In some examples, the thickness of a single-layer spray coating is greater than or equal to 20 µm.

A power device includes a mounting housing, a first connection terminal, a second connection terminal, and at least one PCB. The mounting housing has a mounting cavity. The first connection terminal is disposed in the mounting housing and electrically connected to an external power supply. The second connection terminal is disposed in the mounting housing and used for outputting electrical energy. At least one PCB is electrically connected to both the first connection terminal and the second connection terminal, where at least part of the at least one PCB is covered with a 3D printed protective layer.

In some examples, at least two regions on a PCB of the at least one PCB are covered with the 3D printed protective layer with different thicknesses.

In some examples, a region on a PCB of the at least one PCB is covered with a 3D printed enclosure layer.

In some examples, a region enclosed by the enclosure layer is capable of being covered with a protective layer different from the 3D printed protective layer.

In some examples, the 3D printed protective layer is formed by spraying a PCB of the at least one PCB multiple times.

In some examples, the thickness of a single-layer spray coating is greater than or equal to 20 µm.

A battery pack includes a housing, a cell, and at least one PCB. The housing has an accommodation cavity. The cell is disposed in the accommodation cavity. At least one PCB is electrically connected to the cell, where at least part of the at least one PCB is covered with a 3D printed protective layer.

In some examples, at least two regions on a PCB of the at least one PCB are covered with the 3D printed protective layer with different thicknesses.

In some examples, a region on a PCB of the at least one PCB is covered with a 3D printed enclosure layer.

In some examples, a region enclosed by the enclosure layer is capable of being covered with a protective layer different from the 3D printed protective layer.

In some examples, the 3D printed protective layer is formed by spraying a PCB of the at least one PCB multiple times.

In some examples, the thickness of a single-layer spray coating is less than or equal to 30 µm.

The present application has the beneficial effects below.

The power tool, the power device, and the battery pack provided in the present application each use the PCB as a control unit. When the PCB is covered with the 3D printed protective layer, the automated device is used to accurately coat regions to be protected on the PCB, and 3D printed protective layers may be stacked layer by layer so that the manual glue brushing process is replaced, thereby greatly improving the efficiency and reducing material waste.

### BRIEF DESCRIPTION OF DRAWINGS

FIG. 1 is a schematic view of a power tool according to an example of the present application.
FIG. 2 is a schematic view of a power device according to an example of the present application.
FIG. 3 is a schematic view of another power device according to an example of the present application.
FIG. 4 is a schematic view of another power tool according to an example of the present application.
FIG. 5 is a schematic view of a battery pack according to an example of the present application.
FIG. 6 is a schematic view of a PCB according to an example of the present application.

### DETAILED DESCRIPTION

Before any examples of this application are explained in detail, it is to be understood that this application is not limited to its application to the structural details and the arrangement of components set forth in the following description or illustrated in the above drawings.

In this application, the terms "comprising", "including", "having" or any other variation thereof are intended to cover an inclusive inclusion such that a process, method, article or device comprising a series of elements includes not only those series of elements, but also other elements not expressly listed, or elements inherent in the process, method, article, or device. Without further limitations, an element defined by the phrase "comprising a ..." does not preclude the presence of additional identical elements in the process, method, article, or device comprising that element.

In this application, the term "and/or" is a kind of association relationship describing the relationship between associated objects, which means that there can be three kinds of relationships. For example, A and/or B can indicate that A exists alone, A and B exist simultaneously, and B exists alone. In addition, the character "/" in this application generally indicates that the contextual associated objects belong to an "and/or" relationship.

In this application, the terms "connection", "combination", "coupling" and "installation" may be direct connection, combination, coupling or installation, and may also be indirect connection, combination, coupling or installation. Among them, for example, direct connection means that two members or assemblies are connected together without intermediaries, and indirect connection means that two members or assemblies are respectively connected with at least one intermediate members and the two members or assemblies are connected by the at least one intermediate members. In addition, "connection" and "coupling" are not limited to physical or mechanical connections or couplings, and may include electrical connections or couplings.

In this application, it is to be understood by those skilled in the art that a relative term (such as "about", "approximately", and "substantially") used in conjunction with quantity or condition includes a stated value and has a meaning dictated by the context. For example, the relative term includes at least a degree of error associated with the measurement of a particular value, a tolerance caused by manufacturing, assembly, and use associated with the particular value, and the like. Such relative term should also be considered as disclosing the range defined by the absolute values of the two endpoints. The relative term may refer to plus or minus of a certain percentage (such as 1%, 5%, 10%, or more) of an indicated value. A value that did not use the relative term should also be disclosed as a particular value with a tolerance. In addition, "substantially" when expressing a relative angular position relationship (for example, substantially parallel, substantially perpendicular), may refer to adding or subtracting a certain degree (such as 1 degree, 5 degrees, 10 degrees or more) to the indicated angle.

In this application, those skilled in the art will understand that a function performed by an assembly may be performed by one assembly, multiple assemblies, one member, or multiple members. Likewise, a function performed by a member may be performed by one member, an assembly, or a combination of members.

In this application, the terms "up", "down", "left", "right", "front", and "rear" " and other directional words are described based on the orientation or positional relationship shown in the drawings, and should not be understood as limitations to the examples of this application. In addition, in this context, it also needs to be understood that when it is mentioned that an element is connected "above" or "under" another element, it can not only be directly connected "above" or "under" the other element, but can also be indirectly connected "above" or "under" the other element through an intermediate element. It should also be understood that orientation words such as upper side, lower side, left side, right side, front side, and rear side do not only represent perfect orientations, but can also be understood as lateral orientations. For example, lower side may include directly below, bottom left, bottom right, front bottom, and rear bottom.

In this application, the terms "controller", "processor", "central processor", "CPU" and "MCU" are interchangeable. Where a unit "controller", "processor", "central processing", "CPU", or "MCU" is used to perform a specific function, the specific function may be implemented by a single aforementioned unit or a plurality of the aforementioned unit.

In this application, the term "device", "module" or "unit" may be implemented in the form of hardware or software to achieve specific functions.

In this application, the terms "computing", "judging", "controlling", "determining", "recognizing" and the like refer to the operations and processes of a computer system or similar electronic computing device (e.g., controller, processor, etc.).

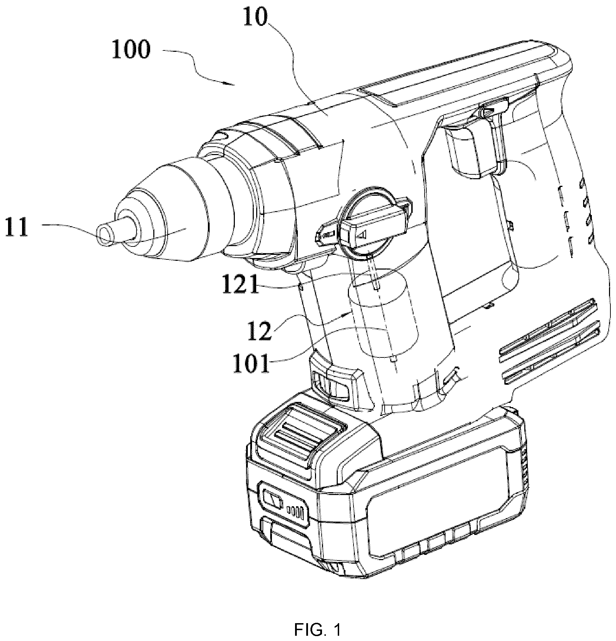

As shown in FIG. 1, the present invention provides a power tool. In FIG. 1, the power tool 100 is an electric drill. However, it is to be understood that the present application is not limited to the disclosed examples but may be applied to other types of power tools 100, for example, a hedge trimmer, or a sander. Alternatively, the power tool 100 may be a table tool, for example, a table saw or a miter saw. Alternatively, the power tool 100 may be a push power tool, for example, a push mower or a push snow thrower. Alternatively, the power tool 100 may be a riding power tool, for example, a riding mower, a riding vehicle, or an all-terrain vehicle. Alternatively, the power tool 100 may be a robotic tool, for example, a robotic mower or a robotic snow thrower. In some examples, the power tool 100 may be an electric drill, an electric vehicle, or the like. In some examples, the power tool 100 may be a garden tool, for example, a hedge trimmer, a blower, a mower, or a chainsaw. Alternatively, the power tool 100 may be a decorating tool, for example, a screwdriver, a nail gun, a circular saw, or a sander. In some examples, the power tool 100 may be a vegetation care tool, for example, a string trimmer, a mower, a hedge trimmer, or a chainsaw. Alternatively, the power tool 100 may be a cleaning tool, for example, a blower, a snow thrower, or a cleaning machine. Alternatively, the power tool 100 may be a drilling tool, for example, a drill, a screwdriver, a wrench, or an electric hammer. Alternatively, the power tool 100 may be a sawing tool, for example, a reciprocating saw, a jigsaw, or a circular saw. Alternatively, the power tool 100 may be a table tool, for example, a table saw, a miter saw, a metal cutter, or an electric router. Alternatively, the power tool 100 may be a sanding tool, for example, an angle grinder or a sander. Alternatively, the power tool 100 may be another tool, for example, a machine tool or a fan.

The power tool 100 includes an electric motor 12, an output portion 11, a housing 10, and at least one PCB 4. The electric motor 12 includes a drive shaft 121 rotating about a drive axis 101. The output portion 11 is driven by the electric motor 12 to output power. The housing 10 is used for accommodating the electric motor 12. At least one PCB 4 is electrically connected to the electric motor 12. In this example, the PCB may be a control board of the electric motor 12 or a control board of other additional functions in the power tool 100, for example, an illumination circuit board or a switch circuit board light. Here, the case where the PCB is the control board of the electric motor 12 is used as an example for description. Various electronic components of the electric motor 12 control circuit may be electrically coupled to the PCB so that at least the start and stop, forward and reverse rotation, and the rotational speed of the electric motor 12 can be controlled, thereby driving the output portion 11 to output a driving force to drive the tool accessory to work, for example, to drive the drill bit to drill holes. The PCB 4 is used as the control center of the power tool 100, and many electronic components are disposed on the PCB 4. Therefore, during the manufacturing process, the surface of the PCB 4 needs to be protected. The surface protection of the PCB 4 of the current product adopts the manual hand brushing process with G6 silicone. This method is inefficient, lots of glue materials are wasted, and excess glue on the appearance inspection station needs to be removed, making the process more complicated.

To solve the preceding problems, in the examples of the present application, the automated device is used to adopt 3D printing technologies to accurately coat regions to be protected on the PCB 4, and 3D printed protective layers42 may be stacked layer by layer so that the manual glue brushing process is replaced, thereby greatly improving the efficiency and reducing material waste.

In an example, an image or graphic of the to-be-sprayed region of the PCB to be sprayed with a protective layer may be preset in the 3D printing automated device. After the PCB is placed at a preset position, the automated device can spray the to-be-protected region with the protective material in response to a printing operation. In this example, the spraying accuracy of the automated device when the 3D printing of the protective layer is performed can reach 0.3 mm or higher. The present application does not provide any further explanation on the automated device for implementing automated 3D printing technologies.

In this example, a 3D printed protective layer 42 may be applied to at least one PCB in the power tool 100. For example, the PCB to which the 3D printed protective layer 42 needs to be applied may be selected according to the complexity of the component arrangement or the number of components on the PCB.

In an example, the thickness of the 3D printed protective layer 42 is greater than or equal to 20 µm and less than or equal to 2000 µm, or greater than or equal to 30 µm and less than or equal to 1000 µm, or greater than or equal to 20 µm and less than or equal to 500 µm, or greater than or equal to 20 µm, for example, 30 µm, 31 µm, 32 µm, 35 µm, ..., 50 µm, 51 µm, 52 µm ... In an example, the thickness of the 3D printed protective layer 42 is greater than 25 µm or greater than or equal to 35 µm. By adopting 3D printing technologies, ultraviolet light-emitting diode (UV-LED) solidifies and stacks the glue layer by layer, thereby achieving three-proof (mildew-proof, moistureproof, and salt spray-proof) potting and other protective effects. Moreover, by accurately controlling the thickness of the 3D printed protective layer 42, while the encapsulation protective effect is ensured, the used glue is reduced. Moreover, after UV-LED printing, the protective layer immediately solidifies and forms a 3D printed protective layer 42 without waiting for solidifying, masking, carriers, and other processes. Moreover, two layers of spray coatings can satisfy general requirements, thereby achieving the thin-layer coating.

In some examples, at least two regions 431, 432 on the PCB 4 are covered with the 3D printed protective layer 42 with different thicknesses. The PCB 4 may be divided into different functional regions according to actual requirements, and the thickness of the 3D printed protective layer 42 may be set according to the different functional regions, thereby satisfying the requirements of flexible encapsulation and protection of the different functional regions. Moreover, when the PCB 4 is covered with the 3D printed protective layer 42, the glue is accurately sprayed to the position that requires protection without overflowing or splashing, thereby saving materials.

In some examples, a region on the PCB 4 is covered with a 3D printed enclosure layer 41. By printing the enclosure layer 41, adjacent components in different functional regions can be separated so that when the functional regions are subsequently covered and encapsulated, the glue is only in the region formed by the enclosure layer 41 and does not flow to other functional regions, thereby ensuring a smooth encapsulation process. When the enclosure layer 41 is printed, the height of the enclosure layer 41 needs to be set according to the heights and distances of the components disposed on the PCB 4. After the enclosure layer 41 is printed, the region enclosed by the enclosure layer 41 is filled. Moreover, the enclosure layer 41 can achieve waterproof sealing so that the housing does not need to be provided.

In some examples, the region enclosed by the enclosure layer 41 is capable of being covered with a protective layer 411 different from the 3D printed protective layer 42. For the PCB 4 with higher requirements for local components, the components encapsulated by the enclosure layer may be filled with glue with better protection performance, and UV glue may be used to cover other components, thereby achieving different levels of local protection and achieving a balance between efficiency and reliability.

In some examples, the 3D printed protective layer 42 is formed by spraying the PCB 4 multiple times. By stacking multiple layers of spray coatings, a thicker 3D printed protective layer 42 can be obtained, thereby forming a 3D shape with a certain mechanical strength to satisfy the high protection requirements of products.

In some examples, the thickness of a single-layer spray coating is greater than or equal to 20 µm, for example, 25 µm, 28 µm, 30 µm, 32 µm, 35 µm, ... By setting the thickness of a single-layer spray coating, general protection requirements can be satisfied after two layers are sprayed so that both the efficiency of single-layer spraying and the solidification of the glue are ensured, thereby achieving efficient encapsulation and protection.

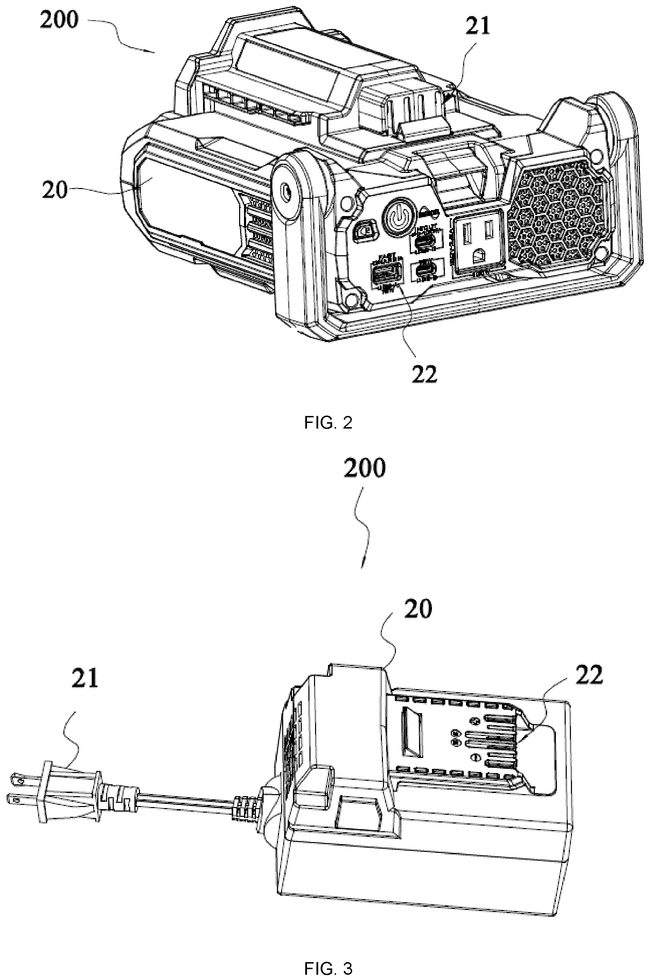

As shown in FIGS. 2 to 4, in some examples, a power device 200 is further provided. The power device 200 may be, but is not limited to, an inverter, an adapter, or a charger. The inverter is a converter that converts direct current (DC) into alternating current (AC). The charger may convert AC into DC or may step down or step up the voltage of DC power and supply the DC power to a charging device. The adapter is an interface converter, may be a separate hardware interface device that allows the hardware or electronic interface to be connected to other hardware or electronic interfaces, or may be an information interface. For example, the adapter may be a power adapter, a tripod base adapter component, an adapter between the Universal Serial Bus (USB) and the serial port, or the like. The adapter is the power conversion device for a small portable electronic device and an electronic appliance.

In some examples, the power device 200 includes a mounting housing 20, a first connection terminal 21, a second connection terminal 22, and at least one PCB 4. The mounting housing 20 has a mounting cavity. The first connection terminal 21 is fixedly disposed in the mounting housing 20 and electrically connected to an external power supply. The second connection terminal 22 is disposed in the mounting housing 20 and used for outputting electrical energy. The PCB 4 is electrically connected to both the first connection terminal 21 and the second connection terminal 22. The PCB 4 can implement functions such as AC/DC conversion, voltage bucking, and voltage boosting. The PCB 4 is used as the control center of the power device 200, so the surface of the PCB 4 needs to be protected during the manufacturing process. The surface protection of the PCB 4 of the current product adopts the manual hand brushing process with G6 silicone. This method is inefficient, lots of glue materials are wasted, and excess glue on the appearance inspection station needs to be removed, making the process more complicated.

To solve the preceding problem, in some examples, at least part of the at least one PCB 4 is covered with a 3D printed protective layer 42. The automated device is used to adopt 3D printing technologies to accurately coat regions to be protected on the PCB 4, and 3D printed protective layers 42 may be stacked layer by layer so that the manual glue brushing process is replaced, thereby greatly improving the efficiency and reducing material waste.

In some examples, at least two regions 431, 432 on the PCB 4 are covered with the 3D printed protective layer 42 with different thicknesses. The PCB 4 may be divided into different functional regions according to actual requirements, and the thickness of the 3D printed protective layer 42 may be set according to the different functional regions, thereby satisfying the requirements of flexible encapsulation and protection of the different functional regions. Moreover, when the PCB 4 is covered with the 3D printed protective layer 42, the glue is accurately sprayed to the position that requires protection without overflowing or splashing, thereby saving materials.

In some examples, any region on the PCB 4 is covered with the 3D printed enclosure layer 41. By printing the enclosure layer 41, adjacent components in different functional regions can be separated so that when the functional regions are subsequently covered and encapsulated, the glue is only in the region formed by the enclosure layer 41 and does not flow to other functional regions, thereby ensuring a smooth encapsulation process. When the enclosure layer 41 is printed, the height of the enclosure layer 41 needs to be set according to the heights and distances of the components disposed on the PCB 4. After the enclosure layer 41 is printed, the region enclosed by the enclosure layer 41 is filled. Moreover, the enclosure layer 41 can achieve waterproof sealing so that the housing does not need to be provided.

In some examples, the region enclosed by the enclosure layer 41 is capable of being covered with a protective layer different from the 3D printed protective layer 42. For the PCB 4 with higher requirements for local components, the components encapsulated by the enclosure layer may be filled with glue with better protection performance, and UV glue may be used to cover other components, thereby achieving different levels of local protection and achieving a balance between efficiency and reliability.

In some examples, the 3D printed protective layer 42 is formed by spraying the PCB 4 multiple times. By stacking multiple layers of spray coatings, a thicker 3D printed protective layer 42 can be obtained, thereby forming a 3D shape with a certain mechanical strength to satisfy the high protection requirements of products.

In some examples, the thickness of a single-layer spray coating is greater than or equal to 20 µm, for example, 25 µm, 28 µm, 30 µm, 32 µm, 35 µm, ... By setting the thickness of a single-layer spray coating, general protection requirements can be satisfied after two layers are sprayed so that both the efficiency of single-layer spraying and the solidification of the glue are ensured, thereby achieving efficient encapsulation and protection.

In some examples, a battery pack 300 is further provided. In the example of the present application, the battery pack 300 may be a liquid lithium-ion battery with a polymer housing 10, a pouch battery, or a hard pack battery using hard materials as a battery housing 10. For example, the housing 10 of the hard pack battery may be made of plastic, steel, or aluminum. Battery cells 33 in the battery pack 300 may be cylindrical cells, square cells, or sheet cells. The battery pack 300 may be a lithium iron phosphate battery, a ternary lithium battery, a sodium-ion battery, or the like.

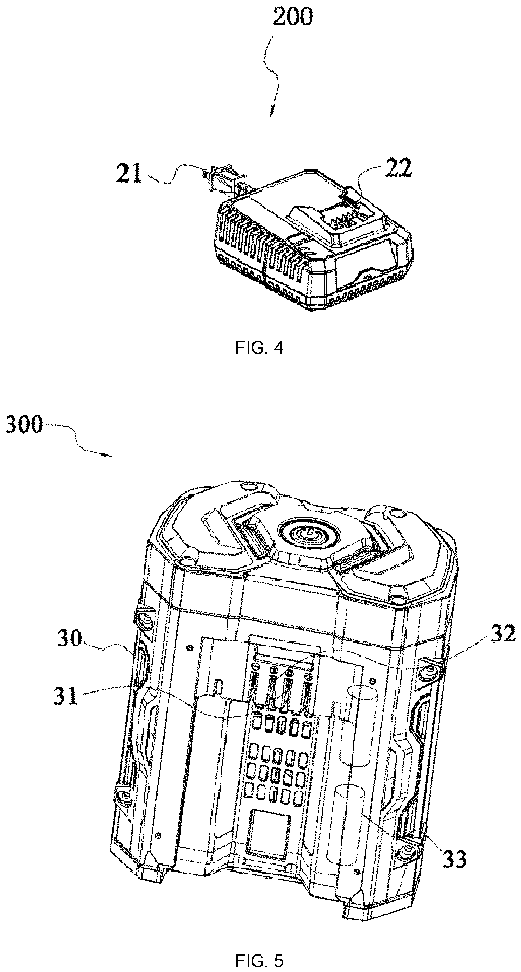

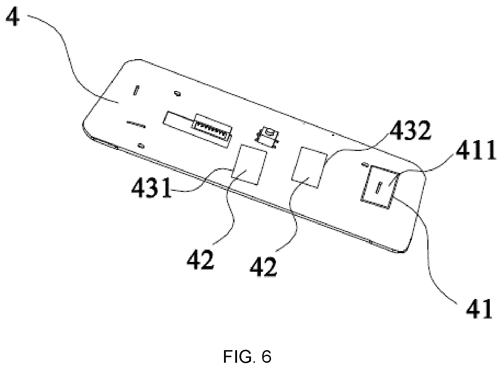

As shown in FIGS. 5 and 6, in some examples, the battery pack 300 includes a housing 30, cells, and at least one PCB 4. The housing 30 has an accommodation cavity. The cells are disposed in the accommodation cavity. The PCB 4 is electrically connected to the cells. Further, the battery pack 300 is provided with a power terminal 31 and a communication terminal 32. The power terminal 31 is used for transmitting power. The communication terminal 32 is used for transmitting communication data. The PCB 4 is electrically connected to the power terminal 31 and the communication terminal 32 and can perform discharge control or charge control. The PCB 4 is used as the control center of the battery pack 300, so the surface of the PCB 4 needs to be protected during the manufacturing process. The surface protection of the PCB 4 of the current product adopts the manual hand brushing process with G6 silicone. This method is inefficient, lots of glue materials are wasted, and excess glue on the appearance inspection station needs to be removed, making the process more complicated.

To solve the preceding problem, in some examples, at least part of the at least one PCB 4 is covered with a 3D printed protective layer 42. The automated device is used to adopt 3D printing technologies to accurately coat regions to be protected on the PCB 4, and 3D printed protective layers 42 may be stacked layer by layer so that the manual glue brushing process is replaced, thereby greatly improving the efficiency and reducing material waste.

In some examples, at least two regions 431, 432 on the PCB 4 are covered with the 3D printed protective layer 42 with different thicknesses. The PCB 4 may be divided into different functional regions according to actual requirements, and the thickness of the 3D printed protective layer 42 may be set according to the different functional regions, thereby satisfying the requirements of flexible encapsulation and protection of the different functional regions. Moreover, when the PCB 4 is covered with the 3D printed protective layer 42, the glue is accurately sprayed to the position that requires protection without overflowing or splashing, thereby saving materials.

In some examples, any region on the PCB 4 is covered with the 3D printed enclosure layer 41. By printing the enclosure layer 41, adjacent components in different functional regions can be separated so that when the functional regions are subsequently covered and encapsulated, the glue is only in the region formed by the enclosure layer 41 and does not flow to other functional regions, thereby ensuring a smooth encapsulation process. When the enclosure layer 41 is printed, the height of the enclosure layer 41 needs to be set according to the heights and distances of the components disposed on the PCB 4. After the enclosure layer 41 is printed, the region enclosed by the enclosure layer 41 is filled. Moreover, the enclosure layer 41 can achieve waterproof sealing so that the housing does not need to be provided.

In some examples, the region enclosed by the enclosure layer 41 is capable of being covered with a protective layer different from the 3D printed protective layer 42. For the PCB 4 with higher requirements for local components, the components encapsulated by the enclosure layer may be filled with glue with better protection performance, and UV glue may be used to cover other components, thereby achieving different levels of local protection and achieving a balance between efficiency and reliability.

In some examples, the 3D printed protective layer 42 is formed by spraying the PCB 4 multiple times. By stacking multiple layers of spray coatings, a thicker 3D printed protective layer 42 can be obtained, thereby forming a 3D shape with a certain mechanical strength to satisfy the high protection requirements of products.

In some examples, the thickness of a single-layer spray coating is greater than or equal to 20 µm, for example, 25 µm, 28 µm, 30 µm, 32 µm, 35 µm, ... By setting the thickness of a single-layer spray coating, general protection requirements can be satisfied after two layers are sprayed so that both the efficiency of single-layer spraying and the solidification of the glue are ensured, thereby achieving efficient encapsulation and protection.

The basic principles, main features, and advantages of this application are shown and described above. It is to be understood by those skilled in the art that the aforementioned examples do not limit the present application in any form, and all technical solutions obtained through equivalent substitutions or equivalent transformations fall within the scope of the present application.

## Claims

1. A power tool (100), comprising:
an electric motor (12) comprising a drive shaft (121) rotating about a drive axis (101);
an output portion (11) driven by the electric motor to output power;
a housing (10) for accommodating the electric motor; and
at least one print circuit board (PCB) (4) electrically connected to the electric motor, wherein at least part of the at least one PCB (4) is covered with a three-dimensional (3D) printed protective layer (42).

2. The power tool of claim 1, wherein a thickness of the 3D printed protective layer is greater than or equal to 20 µm and less than or equal to 2000 µm.

3. The power tool of claim 1, wherein at least two regions (431, 432) on a PCB (4) of the at least one PCB (4) are covered with the 3D printed protective layer with different thicknesses.

4. The power tool of claim 1, wherein a region on a PCB (4) of the at least one PCB (4) is covered with a 3D printed enclosure layer (41).

5. The power tool of claim 4, wherein a region enclosed by the enclosure layer (41) is capable of being covered with a protective layer (411) different from the 3D printed protective layer.

6. The power tool of claim 1, wherein the 3D printed protective layer is formed by spraying a PCB (4) of the at least one PCB (4) multiple times.

7. The power tool of claim 6, wherein a thickness of a single-layer spray coating is greater than or equal to 20 µm.

8. A power device (200), comprising:
a mounting housing (20) having a mounting cavity;
a first connection terminal (21) disposed in the mounting housing (20) and electrically connected to an external power supply;
a second connection terminal (22) disposed in the mounting housing (20) and used for outputting electrical energy to a battery pack (300) capable of supplying power to a power tool (100); and
at least one print circuit board (PCB) (4) electrically connected to both the first connection terminal (21) and the second connection terminal (22), wherein at least part of the at least one PCB (4) is covered with a three-dimensional (3D) printed protective layer.

9. The power device of claim 8, wherein at least two regions (431, 432) on a PCB (4) of the at least one PCB (4) are covered with the 3D printed protective layer with different thicknesses.

10. The power device of claim 8, wherein a region on a PCB (4) of the at least one PCB (4) is covered with a 3D printed enclosure layer (41).

11. The power device of claim 10, wherein a region enclosed by the enclosure layer (41) is capable of being covered with a protective layer (411) different from the 3D printed protective layer.

12. The power device of claim 8, wherein the 3D printed protective layer is formed by spraying a PCB (4) of the at least one PCB (4) multiple times.

13. The power device of claim 12, wherein a thickness of a single-layer spray coating is greater than or equal to 20 µm.

14. A battery pack (300) capable of supplying power to a power tool (100), comprising:
a housing (30) having an accommodation cavity;
a cell (33) disposed in the accommodation cavity; and
at least one print circuit board (PCB) (4) electrically connected to the cell, wherein at least part of the at least one PCB (4) is covered with a three-dimensional (3D) printed protective layer.

15. The battery pack of claim 14, wherein at least two regions (431, 432) on a PCB (4) of the at least one PCB (4) are covered with the 3D printed protective layer with different thicknesses.
